(19) Europäisches Patentamt
European Patent Office
Office européen des brevets

(11) EP 0 758 128 B1

(12) **EUROPÄISCHE PATENTSCHRIFT**

(45) Veröffentlichungstag und Bekanntmachung des Hinweises auf die Patenterteilung:
28.11.2001 Patentblatt 2001/48

(51) Int Cl.⁷: **G11C 11/24**

(21) Anmeldenummer: 95112547.5

(22) Anmeldetag: 09.08.1995

(54) **Speichervorrichtung und Herstellungsverfahren**

Memory device and fabrication method

Dispositif de mémoire et procédé de fabrication

(84) Benannte Vertragsstaaten:
AT DE FR GB IE IT NL

(43) Veröffentlichungstag der Anmeldung:
12.02.1997 Patentblatt 1997/07

(73) Patentinhaber: Infineon Technologies AG
81669 München (DE)

(72) Erfinder:
• Melzner, Hanno
D-82008 Unterhaching (DE)
• Kohlhase, Armin, Dr.
D-85579 Neubiberg (DE)

(74) Vertreter: Epping, Wilhelm, Dipl.-Ing. et al
Epping Hermann & Fischer
Postfach 12 10 26
80034 München (DE)

(56) Entgegenhaltungen:
EP-A- 0 259 614          US-A- 3 970 887

• IBM TECHNICAL DISCLOSURE BULLETIN, Bd. 20, Nr. 12, Mai 1978 NEW YORK US, Seite 5309 K. E. PETERSEN 'Bistable micromechanical storage element in silicon'
• IBM TECHNICAL DISCLOSURE BULLETIN, Bd. 25, Nr. 11b, April 1983 NEW YORK US, Seiten 5874-5875, 'Field Ablation Storage Device'

**Beschreibung**

Die Erfindung bezieht sich auf eine Speichervorrichtung nach dem Oberbegriff des Anspruchs 1 und ein Verfahren zur Herstellung einer Speichervorrichtung nach dem Oberbegriff des Anspruchs 14.

In den vergangenen Jahren wurde die Mikroelektronik zunehmend durch die Mikromechanik ergänzt. Hierbei werden miniaturisierte mechanische Bauteile mittels der Methoden der Mikroelektronik hergestellt. Wegen der physikalischen Grundlagen, der Technologie der Mikromechanik, sowie der bisher bekannten Nutzung der Mikromechanik in Anwendungen mit entsprechenden Grundstrukturen und Elementen der Mikromechanik und Anwendungen mikromechanischer Bauelemente und Komponenten wird auf das Buch von A. Heuberger (Herausgeber), Mikromechanik, 1989 verwiesen.

Grundlage der erfindungsgemäßen Informationsspeicherung ist ein bi- oder mehrfachstabiles System, d.h. ein System, welches in zwei oder gegebenenfalls auch mehr Zuständen zumindest einige Zeit stabil verbleibt. In der Elektronik ist dies beispielsweise ein Flip-Flop, und ein darauf beruhender Speicher ist ein statischer Halbleiterspeicher mit wahlfreiem Zugriff (sogenanntes SRAM). Durch äußere Einwirkung muß ein derartiges System in einen der beiden oder mehrere Zustände verbracht werden können (Schreiben), und es muß von außen feststellbar sein, in welchem Zustand sich das System befindet (Lesen) oder unmittelbar vor dem Lesen befunden hat (Zerstörendes Lesen).

Das rein mechanische bistabile (oder mehrfachstabile) Element für die Speicherzellen stellt eine unter einer kompressiven Spannung stehende Membran dar. Eine derartige Membran wird versuchen, die kompressive Spannung durch Verbiegung zu verringern, d.h. sie wird sich nach oben oder unten durchbiegen. Diese beiden bistabilen Zustände der Membran (nach oben bzw. unten gebogen) sind stabil und lassen sich nur durch Einwirken einer Kraft ineinander überführen.

Derartige Speichervorrichtungen bzw. Herstellungsverfahren sind aus der EP-A-0 259 614 bekannt geworden. Aus dieser Druckschrift, gegen die Ansprüche 1 und 14 abgegrenzt sind, ist weiterhin bekannt, den Lagezustand der Membran entweder vermittels elektrostatischer oder elektromagnetischer Kräfte zu verändern, sowie die Membran entweder als Teil der Steuerelektrode eines MOSFET, oder als den einen Teil eines Plattenkondensators auszubilden. Darüber hinaus ist aus diesem Stand der Technik auch bekannt, die Membran als Lichtleiter auszubilden, der mit einem unterhalb der Membran integriert im Substrat ausgebildeten optischen Sensor in optischer Wechselwirkung steht. In der EP-A-0 259 614 ist außerdem zur Herstellung einer Membran beschrieben, daß auf einem Substrat eine Isolatorschicht aufgebracht wird, auf der anschließend die Membranschicht aufgebracht wird.

In der US-A-3 970 887 ist eine Feldemissionsspitze gezeigt, die für SEM-Mikroskopie oder in hochdichten Elektronenstrahleinrichtungen zur Speicherung und Bereitstellung von Information verwendbar sind. Auf dem Siliziumsubstrat wird ein Isolator abgeschieden, der anschließend selektiv weggeätzt wird, um die Feldemissionsspitze zu erzeugen. Die Anwendung in Zusammenhang mit membranartigen mikromechanischen Speicherelementen spielt keine Rolle.

Eine weitere Speichervorrichtung ist aus IBM Technical Disclosure Bulletin Band 20, Nr. 12, Seite 5309 (Mai 1978) bekannt, bei der eine Speicherzelle als miniaturisiertes mechanisches Element mit einer Membran, welche zwei zwei unterschiedliche bistabile Zustände besitzt, aufgezeigt ist.

Der Erfindung liegt die Aufgabe zugrunde, die gattungsgemäße Speichervorrichtung zur Speicherung erheblicher Datenmengen in Bezug auf das Auslesen zu verbessern, sowie ein Verfahren zur Herstellung einer gattungsbildenden Speichervorrichtung anzugeben.

Diese Aufgabe wird durch eine Speichervorrichtung nach Anspruch 1 und durch ein Verfahren nach Anspruch 14 gelöst.

Bevorzugte Ausführungen der Erfindung sind in den abhängigen Ansprüche angegeben.

Zunächst wird als Hintergrundinformation zum besseren Verständnis die Erfindung das Schreiben in die Zelle erläutert. Der Schreibvorgang ist allerdings nicht Gegenstand der Patentansprüche an sich.

Die beim Schreibzugriff auf die Membran einwirkende Kraft zur ineinander Überführung der unterschiedlichen Informationszustände der Speicherzelle stellt eine elektrostatische Kraft dar. Elektrostatische Kräfte sind bei kleinen Dimensionen hervorragend geeignet, und werden bereits vielfach in der Mikromechanik verwendet. Weiter unten wird anhand einer Berechnung abgeschätzt, daß eine mikromechanische Membran mit einer Spannung in der Größenordnung von 10 V geschaltet werden kann. Bei weiterer linearer Verkleinerung nimmt die erforderliche Schreibspannung linear ab. Die genannte Abschätzung gilt zunächst für eine rechteckige Membran, wobei durch eine geeignete, unter Umständen kompliziertere Form der Membran die erforderliche Schreibspannung weiter verringert werden kann.

Die auf die Membran der Speicherzelle auszuübende Kraft kann auch eine pneumatische Kraft darstellen. Hierbei kann die Membran über einem allseitig geschlossenen gasgefüllten Hohlraum angebracht sein, vermittels dem die Membran pneumatisch betätigt wird. Aus der unteren in die obere Position kann die Membran gezielt beispielsweise durch Aufheizen des Gasvolumens mit einem Laser verbracht werden. Aus der weiter unten folgenden Berechnung ergibt sich, daß der Druck bei pneumatischer Betätigung in der Größenordnung von $1 \times 10^5$ Pa (1 at) betragen muß. Dieser Druck kann durch Aufheizen auf einige 100° Celsius erreicht werden. Ein Umschalten einer individuellen Membran von oben nach unten ist bei dieser Ausführung nicht möglich. Es können jedoch alle Speicherzellen eines Speicher-Arrays durch Einbringen in eine Druckkammer oder dergleichen in die untere Position verbracht werden (Löschen der Speichervorrichtung) und anschließend neu beschrieben werden.

Die Dateninhalte können außerdem optisch ausgelesen werden. Hierbei kann eine Reihe von Effekten wirksam ausgenutzt werden: Die den Speicherzellen zugeordnete Leseeinrichtung kann ein Mittel zur Erfassen der Lichtinterferenz eines Lichtstrahles zwischen der Membran und einer feststehenden Oberfläche besitzen. Alternativ kann vorgesehen sein, daß die Leseeinrichtung ein Mittel zur Erfassung einer Unterbrechung eines durch die Membran führenden Lichtstrahles, oder ein Mittel zur Verstellung eines einem Lichtstrahl der Membran zugeordneten Mikrospiegels besitzt.

Die Daten können aus den Speicherzellen der erfindungsgemäßen Speichervorrichtung außerdem vermittels einem elektromechanischen Lesen ausgelesen werden. Hierbei kann die den Speicherzellen der Speichervorrichtung zugeordnete Leseeinrichtung ein elektromechanisches Schaltmittel aufweisen, welches durch die Membran selbst oder durch ein der Membran zugeordnetes Schaltelement, beispielsweise ein miniaturisiertes Relais, in Abhängigkeit der Zustände der Membran geschaltet wird. Somit schaltet die Membran selbst oder ein an der Membran befestigtes Element je nach Position der Membran einen elektrischen Kontakt ein und aus. Das hier beschrieben optische oder elektromechanische Lesen ist allerdings nicht Gegenstand der Patentansprüche an sich. Das Auslesen der Daten aus den Speicherzellen der Speichervorrichtung kann auf elektronischem Wege erfolgen, wobei hierzu die Kapazität zwischen der Membran und einer feststehenden Oberfläche, welche sich in Abhängigkeit der Position der Membran ändert, erfaßt und ausgewertet wird.

Die den Speicherzellen zugeordnete Leseeinrichtung kann einen Transistor aufweisen, dessen Steueranschluß der Membran zugeordnet ist und/oder die Membran selbst bildet. Die Membran wirkt hierbei als Gate-Anschluß bzw. Steueranschluß des Transistors, welcher vorzugsweise ein MOS-Transistor ist. In Abhängigkeit des Abstandes der Membran von der Halbleiteroberfläche des Transistors ändert sich das elektrische Feld an der Oberfläche, und die Leitfähigkeit des Kanals des Transistors wird verändert.

Zum Auslesen der Daten aus den Speicherzellen ist erfindungsgemäß vorgesehen, daß die den Speicherzellen zugeordnete Leseeinrichtung eine in einem bestimmten Abstand von der Membran angeordnete Feldemissionsspitze aufweist. Insbesondere bei kleinen Dimensionen treten bereits bei mäßigen Spannungen hohe Felder auf. Dieser Effekt ermöglicht unter anderem auch den Bau miniaturisierter "Röhren" mit Feldemissionskathoden. Ändert sich der Abstand der Membran von einer Emissionsspitze, so wird die Leitfähigkeit von der Spitze zur Membran verändert, was zum Auslesen der Daten aus den Speicherzellen verwendet werden kann.

Bei dem Verfahren gemäß der Erfindung kann insbesondere vorgesehen werden, daß quer zu den ersten Leiterbahnen Gräben in der ersten Isolatorschicht geätzt werden, wobei die Membranen als Ätzstopmittel wirken. Hierbei kann am Boden des Grabens eine zweite Leiterbahn hergestellt werden. Des weiteren kann die am Boden des Grabens hergestellte zweite Leiterbahn vermittels eines teilweise durch die dünne Membran hindurch ausgeführten Implantationsschrittes erzeugt werden. Ferner kann vorgesehen sein, daß zur luftdichten Versiegelung der Gräben eine Gegenplatte aufgebracht wird, die an den Stellen der Membranen mit Öffnungen versehen ist.

Zum Auslesen der Dateninhalte aus den Speicherzellen einer Speichervorrichtung, wobei die Speicherzellen ein miniaturisiertes mechanisches Element aufweisen, und die Speicherzellen an Kreuzungsstellen von Wortleitungen und Bitleitungen angeordnet sind, werden folgende Schritte ausgeführt:

- Auswählen einer Wortleitung und einer Bitleitung; und
- Messen des elektrischen Widerstandes der ausgewählten Wortleitung bezüglich der ausgewählten Bitleitung.

Hierbei kann vorgesehen sein, daß der Schritt des Messens des elektrischen Widerstandes der ausgewählten Wortleitung bezüglich der ausgewählten Bitleitung einen Schritt des Vergleichens des gemessenen elektrischen Widerstandes mit dem elektrischen Widerstand einer einen vorbestimmten Schaltzustand aufweisenden Referenzspeicherzelle aufweist.

Zum Einschreiben der Dateninhalte in die Speicherzellen einer Speichervorrichtung, wobei die Speicherzellen ein miniaturisiertes mechanisches Element aufweisen, und die Speicherzellen an Kreuzungsstellen von Wortleitungen und Bitleitungen angeordnet sind, werden folgende Schritte ausgeführt:

- Auswählen einer Wortleitung und einer Bitleitung; und
- Ausüben einer Kraft auf das miniaturisierte mechanische Element der ausgewählten Wortleitung und der ausgewählten Bitleitung.

Die auf das miniaturisierte mechanische Element einwirkende Kraft kann hierbei eine elektrostatische, magnetische oder pneumatische Kraft darstellen.

Weitere Vorteile und Zweckmäßigkeiten der Erfindung ergeben sich aus der Beschreibung von Ausführungsbeispielen anhand der Zeichnung. Es zeigt:

Fig. 1A bis Fig. 1G        schematische Ansichten zur Abschätzung der zum Schalten einer mikromechanischen Membran benötigten Spannung;

Fig. 2A bis 2G        schematische Ansichten zur Erläuterung der Herstellung einer Speichervorrichtung mit miniaturisierten mechanischen Elementen gemäß einem Ausführungsbeispiel der Erfindung; und

Fig. 3A bis 3G        schematische Ansichten zur Erläuterung des Lese- und Schreibvorganges einer Speicherzelle bei der Speichervorrichtung gemäß dem Ausführungsbeispiel der Erfindung.

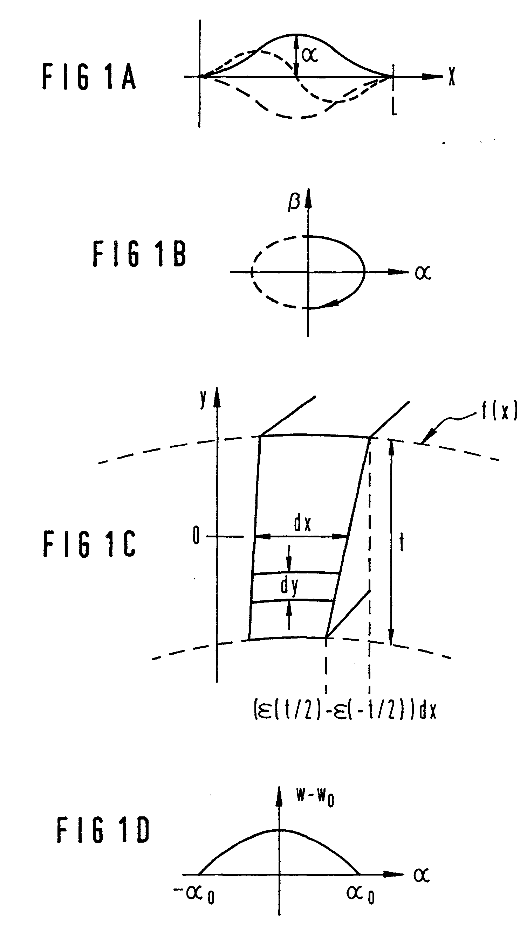

Im folgenden werden zunächst anhand der Fig. 1A bis Fig. 1G die Eigenschaften einer dünnen Membran, welche an den beiden Rändern eingespannt ist, vermittels einer einfachen Berechnung näher untersucht.

Für die Fourierdarstellung einer gemäß Fig. 1A um die Strecke x ausgelenkten Membran der Länge L gilt folgendes:

$$f(x) = \frac{\alpha}{2}\left(1 - \cos\left(\frac{x}{L} \cdot 2\pi\right)\right) + \beta\left(\sin\left(\frac{x}{L} \cdot 2\pi\right) - \frac{1}{2}\sin\left(\frac{x}{L} \cdot 2\pi\right)\right)$$

Die Fourier-Koeffizienten $\alpha$ und $\beta$ werden aus den Randbedingungen wie folgt ermittelt:

$$f(0) = f(L) = 0$$

$$f'(0) = f'(L) = 0$$

Hierbei gilt für die Auslenkung in der Membranmitte, d.h. für x = L/2:

$$f\left(\frac{L}{2}\right) = \alpha$$

Die Ermittlung von $\beta(\alpha)$ ergibt sich aus der Bedingung: Länge der Membran = L + $\Delta$ = konstant.

$$\int_0^L \sqrt{1 + f'^2(x)}\, dx \approx \int_0^L \left(1 + \frac{1}{2}f'^2(x)\right) dx$$

(für kleine Auslenkungen) und damit:

$$= L + \frac{1}{2}\int f'^2(x)\, dx$$

Sei $X = \frac{x}{L} \cdot 2\pi$, dann gilt:

$$f'(x) = \frac{2\pi}{L}\frac{\alpha}{2}\sin X + \beta\frac{2\pi}{L}\cos X - \frac{1}{2}\beta\frac{4\pi}{L}\cos 2X$$

Wegen der Orthogonalität ergibt sich:

$$\int_0^L f'^2(x)\, dx = \left(\frac{2\pi}{L}\frac{\alpha}{2}\right)^2 \frac{L}{2} + \left(\beta\frac{2\pi}{L}\right)\frac{L}{2} + \left(\beta\frac{2\pi}{L}\right)^2 \frac{L}{2} =$$

$$= \frac{L}{2}\left(\frac{2\pi}{L}\right)^2 \left(\frac{\alpha^2}{4} + 2\beta^2\right) = \frac{4\pi^2}{L}\left(\frac{\alpha^2}{8} + \beta^2\right)$$

$$\Delta = \frac{1}{2}\int_0^L f'^2(x)\, dx = \frac{2\pi^2}{L}\left(\frac{\alpha^2}{8} + \beta^2\right)$$

(vgl. Fig. 1B)

$$\Delta \text{ konstant: } \beta = \pm\sqrt{\frac{\Delta \cdot L}{2\pi^2} - \frac{\alpha^2}{8}}$$

und im Grundzustand: $\beta = 0$; dies ergibt:

$$\frac{\alpha_0^2}{8} = \frac{L\cdot\Delta}{2\pi^2} \Rightarrow \beta = \pm\sqrt{\frac{\alpha_0^2}{8} - \frac{\alpha_0^2}{8}} = \pm\frac{\sqrt{2}}{4}\sqrt{\alpha_0^2 - \alpha^2}$$

und

$$\alpha_0 = \sqrt{\frac{4L\cdot\Delta}{\pi^2}} = \frac{2}{\pi}\sqrt{L\Delta}$$

Für den Energieinhalt eines Membranstücks ergibt sich unter Bezugnahme auf die schematische Skizze gemäß Fig. 1C:

$$\varepsilon \sim y$$
$$\delta \sim y$$

$$\frac{\left(\varepsilon\left(\frac{t}{2}\right) - \varepsilon\left(-\frac{t}{2}\right)\right)\cdot dx}{t\cdot dx} = f''(x)$$

$$\Rightarrow \quad \varepsilon = f''(x)\cdot y$$

$$\Rightarrow \quad \delta = \frac{E}{1-\mu}\varepsilon = \frac{E}{1-\mu}f''(x)\cdot y$$

Damit folgt für die Kraft auf ein Volumenelement (wobei die Breite der Membran b ist):

$$F = \delta\cdot dy\cdot b = \frac{E}{1-\mu}\, dy\cdot b\cdot\varepsilon$$

Wegelement: $d\varepsilon\cdot dx$
Damit ergibt sich der Energieinhalt im Volumenelement:

$$W_{dx/dy} = \frac{E}{1-\mu}\,dy\cdot b\cdot dx\cdot\int_0^{2(y)}\varepsilon\,d\varepsilon = \frac{E}{1-\mu}\,dx\,dy\,b\frac{1}{2}\left(\varepsilon(y)\right)^2 =$$

$$= \frac{1}{2}\frac{E}{1-\mu}\,dx\,dy\,b\,f''^2(x)\,y^2$$

und für den Energieinhalt im Membranstück:

$$W_{dx} = \int_{-\frac{t}{2}}^{\frac{t}{2}} W_{dx/dy} = \frac{1}{2}\frac{E}{1-\mu}\,dx\cdot b\cdot f''^2(x)\int_{-\frac{t}{2}}^{\frac{t}{2}} y^2 dy =$$

$$= \frac{1}{2}\frac{E}{1-\mu}\,dx\cdot b\cdot f''^2(x)\,\frac{1}{3}\cdot 2\cdot\frac{t^3}{8} = \frac{1}{24}\frac{E}{1-\mu}\,b\,t^3\,dx\,f''^2(x)$$

Der Energieinhalt in der Membran errechnet sich wie folgt:

$$W = \int_0^L W_{dx} = \frac{1}{24}\frac{E}{1-\mu}\,b\,t^3\int_0^L f''^2(x)dx$$

Sei $X = \frac{x}{L}\cdot 2\pi$, dann gilt:

$$f''(x) = \left(\frac{2\pi}{L}\right)^2\frac{\alpha}{2}\cos X - \beta\left(\frac{2\pi}{L}\right)^2\sin X + \frac{\beta}{2}\left(\frac{4\pi}{L}\right)^2\sin 2X$$

Wegen der Orthogonalität gilt:

$$\int_0^L f''^2(x)dx = \left(\frac{2\pi}{L}\right)^4\left(\frac{\alpha}{2}\right)^2\frac{L}{2} + \left(\frac{2\pi}{L}\right)^4\beta^2\frac{L}{2} + \left(\frac{\beta}{2}\right)^2\left(\frac{4\pi}{L}\right)^4\frac{L}{2} =$$

$$= \frac{\pi^4}{L^3}\left(2\alpha^2 + 8\beta^2 + 32\beta^2\right) = \frac{2\pi^4}{L^3}\left(\alpha^2 + 20\beta^2\right)$$

Aus der Längenbedingung:

$$\beta^2 = \frac{1}{8}(\alpha_0^2 - \alpha^2)$$

folgt:

$$\int_0^L f''^2(x)dx = \frac{\pi^4}{L^3}\left(2\alpha^2 + 5\alpha_0^2 - 5\alpha^2\right) =$$

$$= \frac{\pi^4}{L^3}\left(5\alpha_0^2 - 3\alpha^2\right)$$

und damit:

$$W = \frac{1}{24}\frac{E}{1-\mu}b\,t^3\frac{\pi^4}{L^3}(5\alpha_0^2 - 3\alpha^2)$$

$W_0$ im Grundzustand: $\alpha = \pm\alpha_0$

$$W_0 = \frac{1}{12}\frac{E}{1-\mu}b\,t^3\frac{\pi^4}{L^3}\cdot\alpha_0^2$$

Die Energie relativ zum Grundzustand ergibt sich damit zu (vg1. Fig. 1D):

$$W - W_0 = \frac{1}{8}\frac{E}{1-\mu}bt^3\frac{\pi^4}{L^3}(\alpha_0^2 - \alpha^2)$$

Bei der folgenden Betrachtung wird die Membran als Plattenkondensator behandelt. Start in unterer Ruheposition

Sei $X = \frac{x}{L}\cdot 2\pi$

$$f_0(x) = -\frac{\alpha_0}{2}\cdot(1-\cos X)$$

$$f(x) = \frac{\alpha}{2}(1 - \cos X) + \frac{\sqrt{2}}{4}\sqrt{\alpha_0^2 - \alpha^2}\left(\sin X - \frac{1}{2}\sin 2X\right)$$

Bei Auslenkung ist der zurückgelegte Weg eines Membranelementes:

$$s(x) = f(x) - f_0(x) =$$

$$= \frac{\alpha + \alpha_0}{2}(1 - \cos X) + \frac{\sqrt{2}}{4}\sqrt{\alpha_0^2 - \alpha^2}\left(\sin X - \frac{1}{2}\sin 2X\right)$$

und damit ergibt sich für die Kraft auf ein Membranelement (dx · b) im Plattenkondensator:

$$F = \frac{1}{2}\varepsilon_0\frac{U^2}{d^2}dx\cdot b \text{ (wobei d >> Auslenkung)}$$

Die bei der Auslenkung aufgenommene Energie ergibt sich aus:

$$W = \int_0^{L(L/2)} F \cdot s(x)\, dx$$

Im weiteren sind zwei Fälle zu unterscheiden:

1. Fall: Ganze Membran im Kondensator

$$\int_0^L s(x)\, dx = \frac{L}{2}\left(\alpha + \alpha_0\right)$$

(alle anderen Summ. periodisch $\Rightarrow \int = 0$)

$$W = \frac{1}{2}\,\varepsilon_0 \frac{U^2}{d^2} \cdot b \cdot \frac{L}{2}(\alpha+\alpha_0) = \frac{U^2}{4d^2}\varepsilon_0 bL(\alpha+\alpha_0)$$

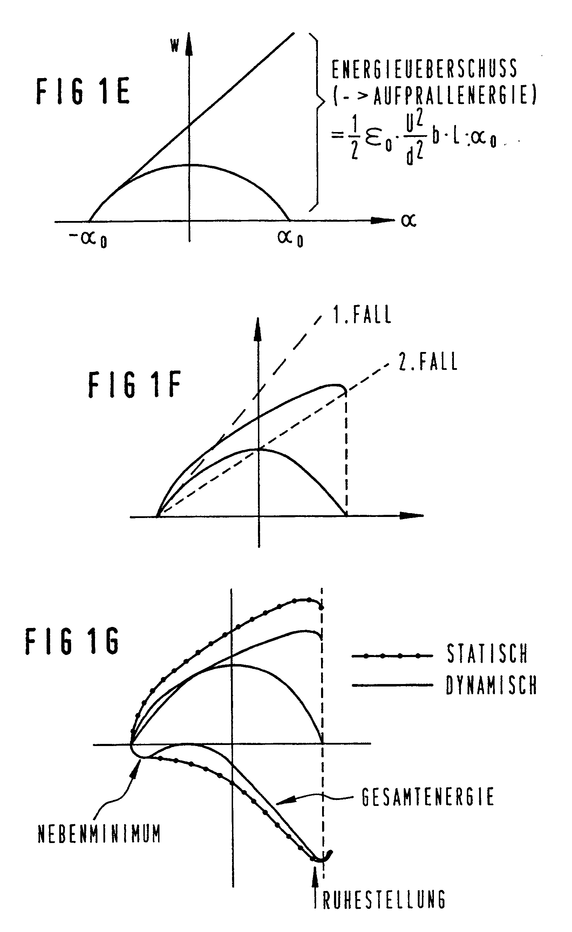

$$\text{Energieüberschuß} = \frac{1}{2}\varepsilon_0 \frac{U^2}{d^2} bL\alpha_0 \quad (\text{vgl. Fig. 1E})$$

Der Schaltvorgang setzt ein, wenn die Steigungen bei $-\alpha_0$ gleich sind.
Steigung potentielle Energie:

$$\frac{1}{4}\frac{E}{1-\mu}bt^3\frac{\pi^4}{L^3}\alpha_0$$

Steigung elektrische Energie:

$$\frac{1}{4}\varepsilon_0\frac{U^2}{d^2}bL$$

$$\frac{E}{1-\mu}t^3\frac{\pi^4}{L^3}\alpha_0 = \varepsilon_0\frac{U^2}{d^2}L \Rightarrow$$

$$U = \frac{d\pi^2}{L^2}\sqrt{\frac{E}{1-\mu}t^3\frac{\alpha_0}{\varepsilon_0}}$$

Damit ergibt sich für das folgende Beispiel:
Si-Membran, d.h. $E/(1-\mu) = 184\cdot10^9$ N/m$^2$

$t = 10$ nm
$d = 100$ nm
$L = 1\ \mu$m
$\alpha_0 = 20$ nm
$\varepsilon_0 = 8,85\cdot10^{-12}$ As/Vm $\Rightarrow U = 20$ V

2. Fall: Halbe Membran im Plattenkondensator

$$\int_0^{L/2} s(x)\, dx = \left[ (\alpha + \alpha_0)\frac{x}{2} - (\alpha + \alpha_0)\frac{L}{4\pi}\sin X - \sqrt{\alpha_0^2 - \alpha^2}\left(\frac{L}{2\pi}\cos X - \frac{L}{8\pi}\cos 2X\right) \right]_0^{L/2}$$

$$= \frac{L}{4}(\alpha + \alpha_0) + \frac{L\sqrt{2}}{4\pi}\sqrt{\alpha_0^2 - \alpha^2} = \frac{L}{4}\left(\alpha + \alpha_0 + \frac{\sqrt{2}}{\pi}\sqrt{\alpha_0^2 - \alpha^2}\right)$$

$$W = \frac{\varepsilon_0 bL}{8}\frac{U^2}{d^2}\left(\alpha + \alpha_0 + \frac{\sqrt{2}}{\pi}\sqrt{\alpha_0^2 - \alpha^2}\right)$$

Es gibt 2 Unterfälle (vg1. Fig. 1F) :

- statisches Schalten
  Auf jedem Wegstück ist Energiegewinn > Energieverlust; Gesamtenergie monoton fallend. Kraft auf Membrane immer positiv, schaltet auch bei Dämpfung.

- dynamisches Schalten
  kumulierter Energiegewinn > kumulierter Energieverlust. Membrane benötigt kinetische Energie zur Überwindung von Energieminima. Bei Dämpfung verbleibt Membran in Nebenminima (vgl. Fig. 1G).

Die benötigte Spannung ist hierbei etwas geringer als im 1. Fall (ganze Membran im Plattenkondensator).

Damit kann eine grobe Abschätzung der Schaltzeit (Schreibezeit) wie folgt angegeben werden:

Kraft auf Membran

$$F \approx \frac{1}{2}\varepsilon_0 \frac{U^2}{d^2}Lb$$

Masse der Membran

$$m = tbL\rho$$

Beschleunigung der Membran

$$a = \frac{1}{2}\frac{\varepsilon_0}{t\rho}\frac{U^2}{d^2}$$

Weg

$$s \;=\; \frac{1}{2}a\tau^2 \xrightarrow{\;\;!\;\;} 2\alpha_0$$

$$\tau = 2\sqrt{\frac{\alpha_0}{a}} = \frac{2d}{U}\sqrt{\alpha_0\frac{2t\rho}{\varepsilon_0}}$$

Mit $\rho = 3000$ kg/m$^3$ $\quad\Rightarrow\quad$ $\tau = 3{,}7$ ns
$a = 5{,}9\cdot 10^9$ m/s$^2$

U = 20 V $\qquad$ Dimensionen wie oben (d.h. äußere Erschütterungen vernachlässigbar).

Dimensionsskalierung: $\qquad$ U $\sim$ Lineardimension (z.B. halbe Größe $\rightarrow$ halbe Spannung).

Bei einer pneumatischen Betätigung der Membran gilt folgendes:

Kraft auf Membranelement:

$$F = p\ dx{\cdot}b$$

$$W = \frac{1}{2}pbL(\alpha+\alpha_0)$$

Steigung $\qquad = \frac{1}{2}pbL$

$$\frac{1}{2}\ \frac{E}{1-\mu}\ bt^3\frac{\pi^4}{L^3}\alpha_0 = \frac{1}{2}pbL$$

$$p = \frac{1}{2}\ \frac{E}{1-\mu}\ t^3\frac{\pi^4}{L^4}\alpha_0$$

Beispiel (Dimensionen wie oben):
p = 180 000 N/m$^2$ $\approx 1{,}8$ bar

Dimensionsskalierung
p unabhängig von Skalierungsfaktor (!).

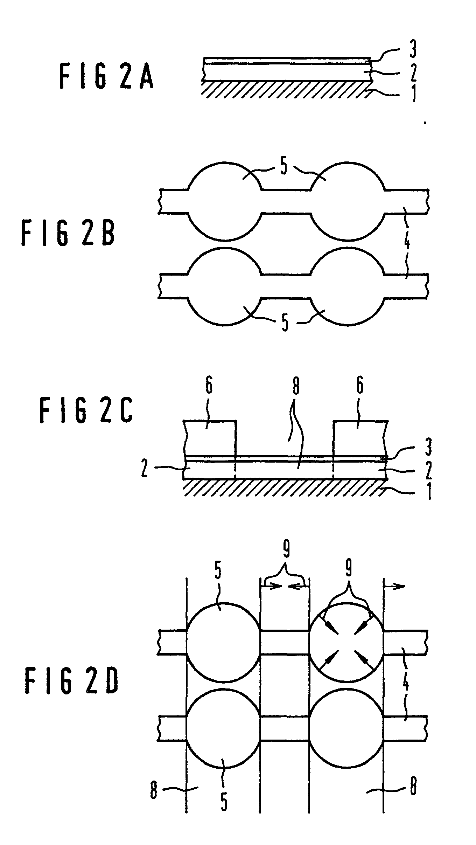

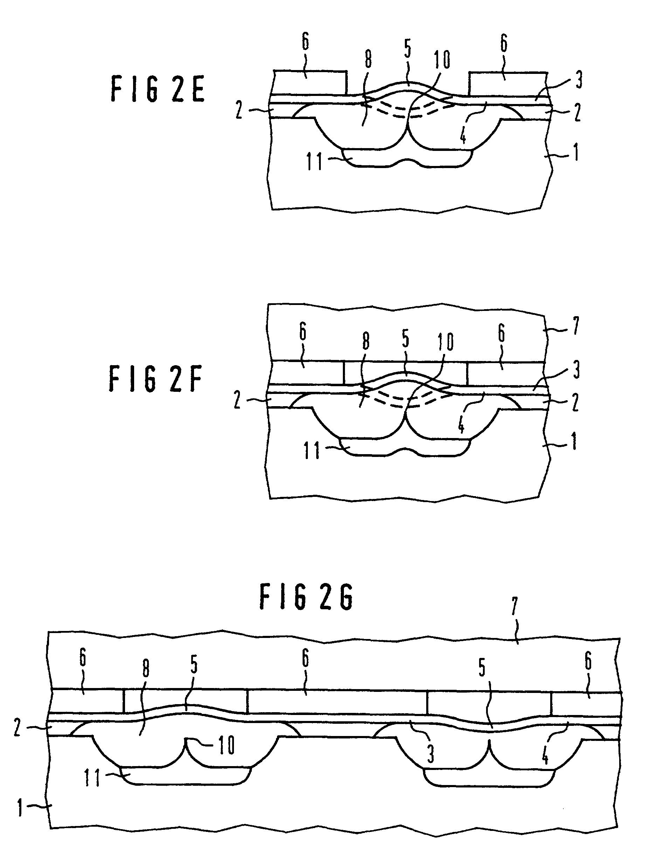

Die Fig. 2A bis 2G zeigen den Ablauf des Verfahrens zur Herstellung einer Speichervorrichtung gemäß einem Ausführungsbeispiel der Erfindung. Gemäß der schematischen Schnittansicht nach Fig. 2A wird zunächst auf einem geeigneten Träger bzw. Substrat 1 eine erste Isolatorschicht 2 beispielsweise mit einer Stärke von etwa 50 nm ganzflächig aufgebracht. Daran anschließend wird auf der Isolatorschicht 2 eine aus elektrisch leitendem Material bestehende Membranschicht 3 ganzflächig aufgetragen, aus der später die Membran der Speicherzelle ausgebildet wird. Die Membranschicht 3 besitzt eine Stärke von beispielsweise 10 nm. Anschließend wird die elektrisch leitende Membranschicht 3 mittels Lithografie und Ätzschritten derart strukturiert, daß eine Vielzahl nebeneinander liegender und voneinander elektrisch isolierter Leiterbahnen 4 hergestellt werden, die an den Stellen der späteren Speicherzellen Verbreiterungen 5 besitzen, die beispielsweise eine kreisförmige Fläche besitzen, wie es aus der schematischen Draufsicht nach Fig. 2B ersichtlich ist. Die Leiterbahnen 4 dienen als Wortleitungen zur selektiven Auswahl einer Zeile von Speicherzellen. Gemäß der schematischen Schnittansicht nach Fig. 2C wird daran anschließend eine zweite Isolatorschicht 6 mit einer Stärke von beispielsweise etwa 100 nm aufgebracht und gegebenenfalls völlig plangeschliffen, beispielsweise vermittels eines an sich bekannten CMP-Verfahrens, um später eine hermetische Verklebung mit einem zweiten Träger 7 bzw. Wafer zu ermöglichen. Senkrecht zu den Wortleitungen 4 werden in den beiden Isolatorschichten 2 und 6 Gräben 8 geätzt, wobei die Verbreiterungen 5 (spätere Membranen) als Ätzstopmittel wirken. Daran anschließend wird das Substrat 1 isotrop geätzt, wie aus der schematischen Draufsicht nach Fig. 2D ersichtlich ist. Die in dieser Figur angedeuteten Pfeile 9 bezeichnen hierbei die Richtung der stattfindenden Unterätzung. In der Mitte unterhalb der Verbreiterung 5 der Membran werden sich die sich bei der isotropen Ätzung ausbildenden Ätzfronten treffen, und es wird gemäß Fig. 2E eine scharfe Spitze 10 zurückbleiben.

Die elektrostatischen Eigenschaften solcher Feldemitterspitzen sind beispielsweise in dem Aufsatz von Takao Utsumi, IEEE TRANSACTIONS ON ELECTRON DEVICES, VOL. 38, No. 10, OCTOBER 1991, Keynote Address Vacuum Microelectronics: What's New and Exciting, eingehend erläutert; wegen dieser Eigenschaften der Feldemissionspitzen wird daher auf diesen Aufsatz verwiesen.

Nach der Ausbildung der Spitze 10 wird die isotrope Substratätzung beendet, und die erste Isolatorschicht 2 wird soweit isotrop überätzt, daß sämtliches Material der Isolatorschicht 2 an der Unterseite der Membran entfernt wird. Daran anschließend wird durch eine Implantation, welche teilweise durch die dünne Membran hindurch ausgeführt wird, eine zweite Leiterbahn 11 für die quer zu den Wortleitungen verlaufenden Bitleitungen am Boden des Grabens 8 hergestellt (vg1. die schematische Schnittanschicht gemäß Fig. 2E). Daran anschließend wird gemäß Fig. 2F der zweite Wafer 7 aufgeklebt, welcher die Gegenelektrode (Masse) bildet, und gleichzeitig die Gräben 8 luftdicht versiegelt. Auf diese Weise ergibt sich die in der Schnittansicht gemäß Fig. 2G näher dargestellte Anordnung einer erfindungsgemäßen Speichervorrichtung.

Der vollständige Ablauf der eigentlichen Herstellung der erfindungsgemäßen Speichervorrichtung erfordert lediglich zwei Maskenebenen, wobei zur Integration einer nicht näher dargestellten Ansteuerungslogik unter Umständen weitere Maskenebenen erforderlich sind.

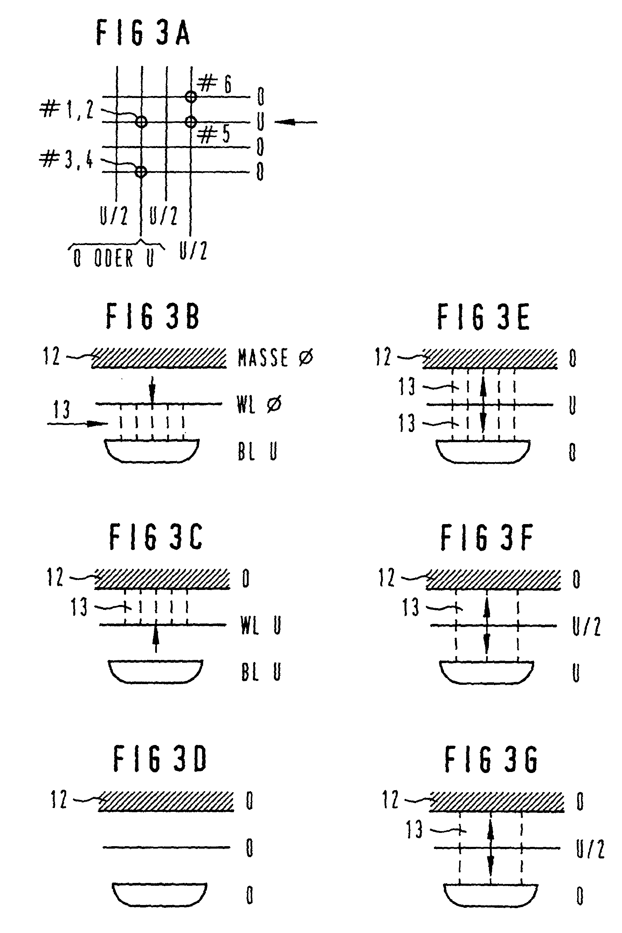

Unter Bezugnahme auf die Fig. 3A bis Fig. 3G werden die zum Lesen und Schreiben eines Dateninhalts einer ausgewählten Speicherzelle erforderlichen Vorgänge näher erläutert.

Zum Lesen wird einfach der elektrische Widerstand einer Wortleitung zu einer Bitleitung gemessen und vorzugsweise mit dem elektrischen Widerstand einer Referenzzelle bekannten Schaltzustands in der Nähe der ausgewählten Zelle verglichen, um örtliche Geometrieschwankungen auszugleichen. Beim Lesevorgang ist die Wortleitung gegenüber der Bitleitung wegen der Feldemission positiv.

Der Schreibvorgang kann unter Bezugnahme auf die Fig. 3A bis Fig. 3G wie folgt durchgeführt werden. Es werde angenommen, daß die obere Elektrode 12 der Speicherzelle auf der Spannung Null liegt, sämtliche nichtaktiven Bitleitungen ebenfalls auf Null liegen, und sämtliche nichtaktiven Wortleitungen auf U/2 liegen. Die aktive Bitleitung liegt auf U, und die aktive Wortleitung liegt je nach gewünschtem Schaltvorgang auf Null oder U. Insgesamt kommen gemäß Fig. 3A auf diese Weise sechs Situationen #1 bis #6 vor, wobei nur auf die am Kreuzungspunkt der aktiven Leitungen liegende Zellmembran eine Nettokraft ausgeübt wird. Hierbei kann die Geometrie durch zwei Plattenkondensatoren angenähert werden. Kleine Feldkräfte auf nicht angesprochenen Membranen sind unschädlich, da zum Schalten eine gewisse Mindestkraft erforderlich ist. Die Polarität von U ist positiv zu wählen, so daß beim Schreiben keine Feldemission stattfindet. Die Geometrie ist so auszulegen, daß die Lesespannung kleiner ist als die Schreibspannung, um ein unbeabsichtigtes Schalten zu verhindern. Die Situationen #1 bis #6 sind jeweils in den Fig. 3B bis Fig. 3G näher erläutert. Hierbei ist mit den gestrichelten Linien der Verlauf des auf die Membran wirkenden elektrostatischen Feldes 13 angedeutet. Die Pfeile geben jeweils die Richtung der auf die Membran wirkenden Kraft wieder. Fig. 3B zeigt in schematischer Ansicht den Fall der ausgewählten Speicherzelle #1 mit einer Kraftwirkung nach unten, Fig. 3G den Fall der angesprochenen Speicherzelle #2 mit einer Kraftwirkung nach oben. Die Fig. 3D bzw. Fig. 3E zeigen die Fälle der Speicherzellen #3 bzw. #4 auf einer aktiven Wortleitung, und die Fig. 3F bzw. Fig. 3G den Fall der Speicherzelle #5 auf einer aktiven Bitleitung bzw. einer Speicherzelle #6 auf einer nichtaktiven Wortleitung und nichtaktiven Bitleitung.

Die Schreibzeiten können aufgrund einer groben Abschätzung in der Größenordnung einiger nsec abgeschätzt werden. Der beschriebene Speicher bewahrt die Information auch bei Ausfall der Versorgungsspannung und zeichnet sich deshalb auch durch einen extrem kleinen Standby-Strom aus. Wird der obere Wafer 7 vermittels einer an sich bekannten SOI-Technik dünn geschliffen, so läßt sich in dieser Schicht auf leichte Weise auch eine SOI-Ansteuerungslogik integrieren. Einer weitere Möglichkeit besteht darin, eine Ansteuerungslogik vermittels den Methoden der Vakuummikroelektronik ("Mikroröhren") vorzusehen. Eine derartige Logik läßt sich unter Umständen mit besonders geringem Zusatzaufwand realisieren, da die Emissionskathode, eine "Gitter"-Schicht (die Membran), eine Anode (die Masseplatte) und die Vakuumkavitäten bereits in der Speicherzelle vorhanden sind und somit keine zusätzlichen Herstellungsschritte erfordern.

Bei einem weiteren, in den Figuren nicht näher dargestellten Ausführungsbeispiel einer erfindungsgemäßen Speichervorrichtung mit einer Vielzahl von Speicherzellen, welche ein miniaturisiertes mechanisches Element besitzen, kann diese als löschbare Compactdisc ausgebildet sein. Hierbei werden in einem Träger bzw. Substrat zunächst Gruben geätzt. Daran anschließend wird eine Membran aufgebracht, beispielsweise vermittels eines seit kurzem entwickelten Waferbonding-Verfahrens. Hierbei werden zwei Wafer aufeinander gelegt und miteinander verklebt, und daran anschließend wird einer der Wafer weggeätzt.

Wegen näherer Einzelheiten dieser sogenannten SOI-Technologie wird beispielsweise auf den Aufsatz von W.P. Maszara, Microelectronic Engineering 22 (1993) 299-306, Elsevier Science Publishers B.V., Wafer bonding: SOI, generalized bonding, and new structures, verwiesen.

Die Membran stehe unter einem kompressiven Streß. Hierbei kann berücksichtigt werden, daß es Materialien gibt, welche bereits bei der Herstellung, beispielsweise durch Sputtern, einen eingebauten Streß besitzen. Weiterhin kann berücksichtigt werden, daß gewissse chemische Reaktionen, welche mit einer Volumenvergrößerung einhergehen, ein kompressiver Streß erzeugt werden kann. Ein bekanntes Beispiel herfür stellt die Oxidation von Silizium dar. Weiterhin kann ein kompressiver Streß beispielweise durch Ionenimplantation erzeugt werden. Schließlich lassen sich auch Unterschiede der thermischen Ausdehnung zwischen Substrat und Membran zur Ausbildung eines kompressiven Streß ausnutzen (Bonding bei hoher Temperatur). Die auf diese Weise hergestellten, allseitig eingespannten Membranen der Speicherzellen besitzen zwei stabile Stellungen. Zunächst wird die Speichervorrichtung durch Ausüben eines Drucks von außen gelöscht, beispielsweise unter Zuhilfenahme einer Druckkammer oder dergleichen und einem Luftstrahl mit einem Druck in der Größenordnung $1 \times 10^5$ Pa (1 at). Ein Schreibvorgang kann durch gezieltes Erwärmen einzelner Speicherzellen mittels einem Laser bei einer Temperatur von einigen 100° Celsius erfolgen.

## Patentansprüche

1. Speichervorrichtung mit einer Vielzahl von auf einem Träger angeordneten Speicherzellen zur wenigstens zeitweise stabilen Speicherung wenigstens zweier unterschiedlicher Informationszustände, mit einer den Speicherzellen zugeordneten Schreibeinrichtung, die selektiv eine der Vielzahl von Speicherzellen durch äußere Einwirkung in einen vorbestimmten Informationszustand bringt, und mit einer den Speicherzellen zugeordneten Leseeinrichtung zur äußeren Erfassung eines Informationszustandes einer ausgewählten Speicherzelle, wobei die Speicherzellen jeweils ein miniaturisiertes mechanisches Element mit einer unter einer kompressiven Spannung stehenden mikromechanischen Membran (5) aufweisen,
**dadurch gekennzeichnet, daß**
die den Speicherzellen zugeordnete Leseeinrichtung eine in einem bestimmten Abstand von der Membran (5) angeordnete scharfe Spitze (10) aufweist.

2. Speichervorrichtung nach Anspruch 1, **dadurch gekennzeichnet, daß** die unter Spannung stehende Membran (5) des miniaturisierten mechanischen Elementes über einem allseitig geschlossenen, gasgefüllten Hohlraum (8) angeordnet ist.

3. Speichervorrichtung nach Anspruch 2, **dadurch gekennzeichnet, daß** eine Heizeinrichtung zum Aufheizen des in dem gasgefüllten Hohlraum (8) angeordneten Gasvolumens vorgesehen ist.

4. Speichervorrichtung nach Anspruch 2 oder 3, **dadurch gekennzeichnet, daß** eine Löscheinrichtung in der Form einer Druckkammer oder dergleichen vorgesehen ist, vermittels derer sämtliche Speicherzellen in einen vorbestimmten stabilen Zustand verbracht werden können.

5. Speichervorrichtung nach einem der Ansprüche 1 bis 4, dadurch gekennzeichent, dass die den Speicherzellen zugeordnete Leseeinrichtung ein Mittel zur Erfassung der Licht-Interferenz eines Lichtstrahles zwischen der Membran (5) und einer feststehenden Oberfläche aufweist.

6. Speichervorrichtung nach einem der Ansprüche 1 bis 4, dadurch gekennzeichent, dass die den Speicherzellen zugeordnete Leseeinrichtung ein Mittel zur Erfassung einer Unterbrechung eines durch die Membran (5) führenden Lichtstrahles und/oder ein Mittel zur Verstellung eines einem Lichtstrahl zugeordneten Mikrospiegels aufweist.

7. Speichervorrichtung nach einem der Ansprüche 1 bis 6,
**dadurch gekennzeichnet, daß** das miniaturisierte mechanische Element der Speicherzelle unterschiedliche bistabile Zustände besitzt, welche den zu speichernden Informationszuständen entsprechen.

8. Speichervorrichtung nach einem der Ansprüche 1 bis 7, **dadurch gekennzeichnet, daß** die Durchbiegungen der mikromechanischen Membran (5) den wenigstens zeitweise stabilen Informationszuständen entsprechen, wobei die Durchbiegungen durch Einwirkung einer Kraft eineinander überführbar sind.

9. Speichervorrichtung nach Anspruch 8, **dadurch gekennzeichnet, daß** die auf die Membran (5) einwirkende Kraft zur ineinander Überführung der unterschiedlichen Informationszustände eine elektrostatische oder pneumatische Kraft darstellt.

10. Speichervorrichtung nach Anspruch 8, **dadurch gekennzeichnet, daß** die auf die Membran (5) einwirkende Kraft zur ineinander Überführung der unterschiedlichen Informationszustände eine magnetische Kraft darstellt.

11. Speichervorrichtung nach Anspruch 1 bis 10, **dadurch gekennzeichnet, daß** die Leseeinrichtung ein elektromechanisches Schaltmittel aufweist, welches durch die Membran (5) selbst oder durch ein der Membran (5) zugeordnetes Schaltelement in Abhängigkeit der Zustände der Membran (5) geschaltet wird.

12. Speichervorrichtung nach Anspruch 1 bis 11, **dadurch gekennzeichnet, daß** die Leseeinrichtung ein Mittel zur Erfassung der elektrischen Kapazität zwischen der Membran (5) und einer feststehenden Oberfläche aufweist.

13. Speichervorrichtung nach Anspruch 1 bis 12, **dadurch gekennzeichnet, daß** die den Speicherzellen zugeordnete Leseeinrichtung einen Transistor aufweist, dessen Steueranschluß der Membran (5) zugeordnet ist und/oder die Membran (5) bildet.

14. Verfahren zur Herstellung einer Speichervorrichtung mit einer Vielzahl von Speicherzellen, die jeweils ein miniaturisiertes mechanisches Element aufweisen, mit den Schritten:

  - ganzflächiges Aufbringen einer ersten Isolatorschicht (2) auf die Hauptfläche eines Trägers (1);
  - ganzflächiges Aufbringen einer Membranschicht (3) aus einem elektrisch leitenden Material auf die erste Isolatorschicht (2);

  **gekennzeichnet durch**
  die weiteren Schritte:

  - Strukturieren der Membranschicht (3) derart, daß erste Leiterbahnen (4) ausgebildet werden, die an den Stellen der Speicherzellen Verbreiterungen (5) besitzen;
  - isotropes Ätzen der ersten Isolatorschicht (2) unter Verwendung der strukturierten Membranschicht (3) als Ätzmaske so lange, bis in der Mitte unmittelbar unterhalb der Verbreiterung (5) der Membranschicht (3) eine scharfe Spitze (10) zurückbleibt; und
  - Entfernen von sämtlichem Material der ersten Isolatorschicht (2) an der Unterseite der Verbreiterung (5) und **dadurch** Ausbildung einer Membran (5).

15. Verfahren nach Anspruch 14, **dadurch gekennzeichnet, daß** quer zu den ersten Leiterbahnen (4) Gräben (8) in der ersten Isolatorschicht (2) geätzt werden, wobei die Membranen (5) als Ätzstopmittel wirken.

16. Verfahren nach Anspruch 14 oder 15, **dadurch gekennzeichnet, daß** am Boden des Grabens (8) eine zweite Leiterbahn (11) hergestellt wird.

17. Verfahren nach Anspruch 16, **dadurch gekennzeichnet, daß** die am Boden des Grabens (8) hergestellte zweite Leiterbahn (11) vermittels eines teilweise durch die dünne Membran (5) hindurch ausgeführten Implantationschrittes erzeugt wird.

18. Verfahren nach Anspruch 15 bis 17, **dadurch gekennzeichnet, daß** zur luftdichten Versiegelung der Gräben (8) eine Gegenplatte aufgebracht wird, die an den Stellen der Membranen (5) mit Öffnungen versehen ist.

## Claims

1. Memory device having a multiplicity of memory cells arranged on a support and serving for at least occasionally stably storing at least two different information states, having a writing device which is assigned to the memory cells and selectively brings one of the multiplicity of memory cells into a predetermined information state by external action, and having a reading device assigned to the memory cells and serving for externally detecting an information state of a selected memory cell, the memory cells each having a miniaturized mechanical element having a compressively stressed micromechanical diaphragm (5),
**characterized in that**
the reading device assigned to the memory cells has a sharp tip (10) arranged at a specific distance from the diaphragm (5).

2. Memory device according to Claim 1, **characterized in that** the stressed diaphragm (5) of the miniaturized mechanical element is arranged above a gas-filled cavity (8) which is closed on all sides.

3. Memory device according to Claim 2, **characterized in that** provision is made of a heating device for heating the gas volume arranged in the gas-filled cavity (8).

4. Memory device according to Claim 2 or 3,
   **characterized in that** provision is made of an erasing device in the form of a pressure chamber or the like, by means of which all the memory cells can be put into a predetermined stable state.

5. Memory device according to one of Claims 1 to 4,
   **characterized in that** the reading device assigned to the memory cells has a means for detecting the light interference of a light beam between the diaphragm (5) and a stationary surface.

6. Memory device according to one of Claims 1 to 4,
   **characterized in that** the reading device assigned to the memory cells has a means for detecting an interruption of a light beam passing through the diaphragm (5) and/or a means for adjusting a micromirror assigned to a light beam.

7. Memory device according to one of Claims 1 to 6,
   **characterized in that** the miniaturized mechanical element of the memory cell has different bistable states which correspond to the information states to be stored.

8. Memory device according to one of Claims 1 to 7,
   **characterized in that** the flexures of the micromechanical diaphragm (5) correspond to the at least occasionally stable information states, the flexures being able to be mutually changed over by the action of a force.

9. Memory device according to Claim 8, **characterized in that** the force acting on the diaphragm (5) for the purpose of mutually changing over the different information states constitutes an electrostatic or pneumatic force.

10. Memory device according to Claim 8, **characterized in that** the force acting on the diaphragm (5) for the purpose of mutually changing over the different information states constitutes a magnetic force.

11. Memory device according to Claims 1 to 10,
    **characterized in that** the reading device has an electromechanical switching means which is switched by the diaphragm (5) itself or by a switching element assigned to the diaphragm (5), in a manner dependent on the states of the diaphragm (5).

12. Memory device according to Claims 1 to 11,
    **characterized in that** the reading device has a means for detecting the electrical capacitance between the diaphragm (5) and a stationary surface.

13. Memory device according to Claims 1 to 12,
    **characterized in that** the reading device assigned to the memory cells has a transistor whose control terminal is assigned to the diaphragm (5) and/or forms the diaphragm (5).

14. Method for fabricating a memory device having a multiplicity of memory cells which each have a miniaturized mechanical element, having the following steps:

    - whole-area application of a first insulator layer (2) to the main area of a support (1);
    - whole-area application of a diaphragm layer (3) made of an electrically conductive material to the first insulator layer (2);

    **characterized by**
    the following further steps:

    - patterning of the diaphragm layer (3) in such a way as to form first interconnects (4) which have widened portions (5) at the locations of the memory cells;

- isotropic etching of the first insulator layer (2) using the patterned diaphragm layer (3) as an etching mask until a sharp tip (10) remains in the centre directly below the widened portion (5) of the diaphragm layer (3); and
- removal of all material of the first insulator layer (2) on the underside of the widened portion (5) and thus formation of a diaphragm (5).

15. Method according to Claim 14, **characterized in that** trenches (8) are etched in the first insulator layer (2) transversely with respect to the first interconnects (4), the diaphragms (5) acting as etching stop means.

16. Method according to Claim 14 or 15, **characterized in that** a second interconnect (11) is fabricated at the bottom of the trench (8).

17. Method according to Claim 16, **characterized in that** the second interconnect (11) fabricated at the bottom of the trench (8) is produced by means of an implantation step which is partly carried out through the thin diaphragm (5).

18. Method according to Claims 15 to 17, **characterized in that** a mating plate is applied for airtight sealing of the trenches (8), which plate is provided with openings at the locations of the diaphragms (5).


**Revendications**

1. Dispositif de mémoire comportant une multiplicité de cellules de mémoire disposées sur un support pour la mémorisation au moins temporairement stable d'au moins deux états d'information différents, comportant un dispositif d'écriture associé aux cellules de mémoire qui, par une action externe, met sélectivement l'une de la multiplicité de cellules de mémoire dans un état d'information prescrit, et comportant un dispositif de lecture associé aux cellules de mémoire pour l'enregistrement externe d'un état d'information d'une cellule de mémoire sélectionnée, les cellules de mémoire comportant chacune un élément mécanique miniaturisé doté d'une membrane (5) micromécanique soumise à une contrainte de compression,
**caractérisé en ce que** le dispositif de lecture associé aux cellules de mémoire comporte une pointe (10) acérée disposée à une distance donnée de la membrane (5).

2. Dispositif de mémoire suivant la revendication 1, **caractérisé en ce que** la membrane (5) sous contrainte de l'élément mécanique miniaturisé est disposée au-dessus d'une cavité (8) fermée de tous côtés et remplie de gaz.

3. Dispositif de mémoire suivant la revendication 2, **caractérisé en ce qu'**un dispositif de chauffage est prévu pour chauffer le volume de gaz disposé dans la cavité (8) remplie de gaz.

4. Dispositif de mémoire suivant la revendication 2 ou 3,
**caractérisé en ce qu'**il est prévu un dispositif d'effacement sous la forme d'une chambre de pression ou analogue, au moyen duquel toutes les cellules de mémoire peuvent être mises dans un état stable prédéfini.

5. Dispositif de mémoire suivant l'une des revendications 1 à 4,
**caractérisé en ce que** le dispositif de lecture associé aux cellules de mémoire comporte un moyen pour enregistrer l'interférence lumineuse d'un faisceau lumineux entre la membrane (5) et une surface fixe.

6. Dispositif de mémoire suivant l'une des revendications 1 à 4,
**caractérisé en ce que** le dispositif de lecture associé aux cellules de mémoire comporte un moyen pour enregistrer une interruption d'un faisceau lumineux traversant la membrane (5) et/ou un moyen pour déplacer un réflecteur miniature associé à un faisceau lumineux.

7. Dispositif de mémoire suivant l'une des revendications 1 à 6,
**caractérisé en ce que** l'élément mécanique miniaturisé de la cellule de mémoire possède des états bistables différents, qui correspondent aux états d'information à mémoriser.

8. Dispositif de mémoire suivant l'une des revendications 1 à 7,
**caractérisé en ce que** les fléchissements de la membrane (5) micromécanique correspondent aux états d'information au moins temporairement stables, les fléchissements pouvant être permutés par l'action d'une force.

9. Dispositif de mémoire suivant la revendication 8, **caractérisé en ce que** la force agissant sur la membrane (5) pour permuter les états d'information différents est une force électrostatique ou pneumatique.

10. Dispositif de mémoire suivant la revendication 8, **caractérisé en ce que** la force agissant sur la membrane (5) pour permuter les états d'information différents est une force magnétique.

11. Dispositif de mémoire suivant l'une des revendications 1 à 10, **caractérisé en ce que** le dispositif de lecture comporte un moyen de commutation électromécanique, qui est commuté par la membrane (5) elle-même ou par un élément de commutation associé à la membrane (5), en fonction des états de la membrane (5).

12. Dispositif de mémoire suivant l'une des revendications 1 à 11, **caractérisé en ce que** le dispositif de lecture comporte un moyen pour enregistrer la capacité électrique entre la membrane (5) et une surface fixe.

13. Dispositif de mémoire suivant l'une des revendications 1 à 12, **caractérisé en ce que** le dispositif de lecture associé aux cellules de mémoire comporte un transistor dont le branchement de commande est associé à la membrane (5) et/ou constitue la membrane (5).

14. Procédé de fabrication d'un dispositif de mémoire comportant une multiplicité de cellules de mémoire qui comportent chacune un élément mécanique miniaturisé, comprenant les étapes suivantes :

   - application sur toute la surface d'une première couche (2) d'isolateur sur la face principale d'un support (1) ;
   - application sur toute la surface d'une couche (3) de membrane, constituée d'un matériau électriquement conducteur, sur la première couche (2) d'isolateur ;

   **caractérisé par** les étapes supplémentaires suivantes :

   - structuration de la couche (3) de membrane de telle sorte que soient formées des premières pistes (4) conductrices qui possèdent des élargissements (5) aux emplacements des cellules de mémoire ;
   - attaque chimique isotrope de la première couche (2) d'isolateur en utilisant la couche (3) de membrane structurée comme masque de décapage, jusqu'à ce qu'une pointe (10) acérée reste au milieu, juste en dessous de l'élargissement (5) de la couche (3) de membrane ; et
   - enlèvement de la totalité du matériau de la première couche (2) d'isolateur sur le dessous de l'élargissement (5), en formant ainsi une membrane (5).

15. Procédé suivant la revendication 14, **caractérisé en ce que** des sillons (8) sont ménagés par attaque chimique dans la première couche (2) d'isolateur transversalement aux premières pistes (4) conductrices, les membranes (5) jouant le rôle d'agent d'arrêt de l'attaque chimique.

16. Procédé suivant la revendication 14 ou 15, **caractérisé en ce qu'**une deuxième piste (11) conductrice est réalisée sur le fond du sillon (8).

17. Procédé suivant la revendication 16, **caractérisé en ce que** la deuxième piste (11) conductrice réalisée sur le fond du sillon (8) est produite au moyen d'une étape d'implantation réalisée partiellement à travers la membrane (5) mince.

18. Procédé suivant l'une des revendications 15 à 17, **caractérisé en ce qu'**il est appliqué pour sceller en étanchéité à l'air les sillons (8), une contre-plaque qui est dotée d'ouvertures aux emplacements des membranes (5).

FIG 1A

FIG 1B

FIG 1C

$$(\varepsilon(t/2)-\varepsilon(-t/2))dx$$

FIG 1D

17

FIG 1E

ENERGIEUEBERSCHUSS
(->AUFPRALLENERGIE)
$= \frac{1}{2}\varepsilon_0 \cdot \frac{U^2}{d^2} b \cdot L \cdot \alpha_0$

FIG 1F

1.FALL
2.FALL

FIG 1G

STATISCH
DYNAMISCH

NEBENMINIMUM

GESAMTENERGIE

RUHESTELLUNG

FIG 2A

3
2
1

FIG 2B

5
4
5

FIG 2C

6    8    6
3
2
2
1

FIG 2D

9    9
5
5
4
8    5    8

F I G 2 E

F I G 2 F

F I G 2 G

# FIG 3A

#6

#1,2

#5

#3,4

0
U
0
0

U/2   U/2

U/2

0 ODER U

# FIG 3B

12 — MASSE ∅

13 — WL ∅

BL U

# FIG 3E

12 — 0

13 —

13 — U

0

# FIG 3C

12 — 0

13 — WL U

BL U

# FIG 3F

12 — 0

13 — U/2

U

# FIG 3D

12 — 0

0

0

# FIG 3G

12 — 0

13 — U/2

0